# EUROPÄISCHE PATENTSCHRIFT

(11) **EP 2 046 490 B1**
(45) Veröffentlichungstag und Bekanntmachung des Hinweises auf die Patenterteilung: **01.04.2015**
(21) Anmeldenummer: 07728798.5
(22) Anmeldetag: 04.05.2007
(51) Int. Cl.: B01D 67/00, B81C 1/00, B01D 71/02, B01D 61/24

(54) **VERFAHREN ZUR HERSTELLUNG EINES BAUELEMENTS MIT PORÖSEM MATERIALBEREICH**
METHOD FOR PRODUCING A COMPONENT HAVING A POROUS MATERIAL PORTION
PROCÉDÉ DE FABRICATION D'UN COMPOSANT AYANT UNE ZONE DE MATERIAU POREUSE

(30) Priorität: 28.06.2006 DE 102006029622
(43) Veröffentlichungstag der Anmeldung: 15.04.2009
(73) Patentinhaber: Robert Bosch GmbH, 70442 Stuttgart (DE)
(72) Erfinder: FUCHS, Tino, 72076 Tuebingen (DE); LEINENBACH, Christina, 66806 Ensdorf (DE)
(86) Internationale Anmeldenummer: PCT/EP2007/054345
(87) Internationale Veröffentlichungsnummer: WO 2008/000541

(56) Entgegenhaltungen:
- US-A1- 2004 033 339
- US-A1- 2004 249 006
- KÖHLER, M: "Etching in Microsystem Technology" 1999, WILEY-VCH , WEINHEIM, GERMANY , XP002451515 ISBN: 3-527-29561-5 Seite 184 - Seite 185
- BERTRAN E ET AL: "Surface analysis of nanostructured ceramic coatings containing silicon carbide nanoparticles produced by plasma modulation chemical vapour deposition" THIN SOLID FILMS, ELSEVIER-SEQUOIA S.A. LAUSANNE, CH, Bd. 377-378, 1. Dezember 2000 (2000-12-01), Seiten 495-500, XP004226741 ISSN: 0040-6090
- CABARROCAS P R ET AL: "EXPERIMENTAL EVIDENCE FOR NANOPARTICLE DEPOSITION IN CONTINUOUS ARGON-SILANE PLASMAS: EFFECTS OF SILICON NANOPARTICLES ON FILM PROPERTIES" JOURNAL OF VACUUM SCIENCE AND TECHNOLOGY A. VACUUM, SURFACES AND FILMS, AMERICAN INSTITUTE OF PHYSICS, NEW YORK, NY, US, Bd. 14, Nr. 2, März 1996 (1996-03), Seiten 655-659, XP009058322 ISSN: 0734-2101
- KIM TAE-WOOK ET AL: "Quantum confinement effect in crystalline silicon quantum dots in silicon nitride grown using SiH4 and NH3" APPLIED PHYSICS LETTERS, AIP, AMERICAN INSTITUTE OF PHYSICS, MELVILLE, NY, US, Bd. 88, Nr. 12, 22. März 2006 (2006-03-22), Seiten 123102-123102, XP012080745 ISSN: 0003-6951

## Beschreibung

### Stand der Technik

Die Erfindung geht aus von einem Verfahren zur Herstellung eines mikromechanischen Bauelements.

Zur Herstellung poröser Schichten aus Silizium und Siliziumcarbid ist es beispielsweise aus der amerikanischen Patentschrift US 5 376 241 A bekannt, elektrochemische Anodisierungsprozesse mit beispielsweise Flusssäure als Ätzmedium zu verwenden. Dieses Verfahren hat entscheidende Nachteile, da es zum einen eine vergleichsweise hohe elektrische Leitfähigkeit der zu porosifizierenden Schicht voraussetzt und da zum anderen das Ätzmittel als Flüssigkeit vorliegt. Die vergleichsweise hohe elektrische Leitfähigkeit ist insbesondere für Siliziumcarbid eine starke Einschränkung, da sich dieses Materialsystem nur mit großem technischen Aufwand dotieren lässt. Das Vorliegend des Ätzmediums als Flüssigkeit und die damit verbundene inhärente Oberflächenspannung des Ätzmediums limitiert die minimal erzeugbaren Porengrößen bei der Porosifizierung. Ein weiterer Nachteil des bekannten Porosifizierungsverfahrens ist der unvermeidbare Umgang mit Flusssäure, was ein enormes Gefährdungspotential bedeutet.

Aus der US 2004/0033339 A1 ist ein Herstellungsverfahren für einen porösen Körper bekannt, bei dem insbesondere Silizium, Germanium oder Mischungen hiervon das Basis-Material bilden, wobei sich aufgrund einer Mischung mit Aluminium Aluminium-Mikrosäulen ausbilden können, die selektiv aus dem Material zur Ausbildung der Poren entfernt werden können.

### Offenbarung der Erfindung

Das erfindungsgemäße Verfahren zur Herstellung eines mikromechanischen Bauelements gemäß einer ersten Ausführungsform hat demgegenüber den Vorteil, dass eine Strukturierung eines Materi-albereichs des Bauelements bereits im ersten Verfahrensschritt möglich ist, so
dass die eigentliche Definition der Strukturierungsparameter bereits in diesem Verfahrensschritt erfolgt, und dass im zweiten Verfahrensschritt ein Ätzschritt zum selektiven Ätzen eines Teils des strukturierten Materialbereichs vorteilhafterweise mittels eines Gasphasenätzschrittes oder mittels eines Trockenätzverfahrens erfolgen kann, so dass von der Oberflächenspannung oder der chemischen Natur eines verwendeten flüssigen Ätzmediums ausgehende negative Einflüsse auf beispielsweise die Porengröße ausbleiben.

Erfindungsgemäß wird der strukturierte Materialbereich im zweiten Schritt dadurch porös geätzt, dass das erste Material selektiv gegenüber dem zweiten Material geätzt wird oder dass das zweite Material selektiv gegenüber dem ersten Material geätzt wird bzw. dass die Mikropartikel des ersten Materials Germanium oder Siliziumgermanium umfassende Mikrokristallite sind und/oder dass die Matrix des zweiten Materials Siliziumcarbid oder Silizium umfasst. Hierdurch ist es vorteilhaft möglich, dass ein Porosifizierungsverfahren ohne elektrischen Stromfluss durch die zu porosifizierende Schicht oder den strukturierten Materialbereich auskommt. Als Trockenätzverfahren ist erfindungsgemäß beispielsweise eine Ätzung mit CIF3-Ätzgas vorgesehen. Als Materialkombination des ersten bzw. zweiten Materials ist erfindungsgemäß beispielsweise Germanium-Material oder Silizium-Germanium-Material bzw. entsprechende Mikrokristallite als erstes Material sowie Siliziumcarbid als zweites Material vorgesehen. Mit dieser Materialkombination kann beispielsweise eine Ätzung mit ClF3-Ätzgas mit einer sehr hohen Selektivität (Ätzung von Germanium bzw. Silizium-Germanium gegenüber Siliziumcarbid von typischerweise etwa 1063 zu 1 bis über etwa 105 zu 1) erfolgen.

Ferner hat das erfindungsgemäße Verfahren zur Herstellung eines mikromechanischen Bauelements gemäß einer zweiten Ausführungsform den Vorteil, dass im ersten Schritt ein Abscheidungsverfahren verwendet wird, bei dem die Mikropartikel innerhalb eines Plasmas aus Vorläuferedukten entstehen, wobei die Vorläuferedukte insbesondere gasförmig sind. Hierdurch ist es erfindungsgemäß überraschend möglich, den Effekt eines sogenannten staubigen Plasmas (dusty plasma) vorteilhaft zur Erzeugung des strukturierten Materialbereichs auszunutzen. Hierbei werden Kristallite bzw. Mikrokristallite des ersten Materials, die in dem Bereich des elektrischen Feldes eines solchen Plasmas zur Materialabscheidung entstehen, zusammen mit dem zweiten Material abgeschieden und dadurch die Strukturierung des strukturierenden strukturierten Materialbereichs erzielt.

Hierbei ist es besonders bevorzugt, wenn bei dem im ersten Schritt zur Herstellung des strukturierten Materialbereichs verwendeten Abscheidungsverfahrens eine Plasmasteuerung zur periodischen Erzeugung und Abscheidung von Mikropartikel verwendet wird, wobei insbesondere die Größe und/oder die Form der Mikropartikel durch eine Variation der Plasmasteuerung verändert wird und wobei insbesondere eine Spannungs-Leistungssteuerung als Plasmasteuerung verwendet wird. Hierdurch kann vorteilhafterweise mit relativ einfachen Mitteln eine Steuerung der Strukturparameter des strukturierten Materialbereichs erzielt werden, beispielsweise dadurch, dass das Plasma bzw. das elektrische Feld zur Aufrechterhaltung des Plasmazustandes oberhalb des Substrats des Bauelements periodisch gepulst wird. Der Puls-Zyklus (der im Folgenden auch als Duty-Cycle des Plasma-Zyklus genannt wird) wird hierbei erfindungsgemäß vorteilhaft derart gestaltet, dass die Einschaltzeit des Plasmas ausreicht, um genügend große Kristallite des ersten Materials im Plasma zu erzeugen, und dass die Ausschaltzeit des Plasmas ausreicht, dass die Entladung vollständig erlischt und dadurch die Kristallite auf die Matrix des zweiten Materials fallen.

Ein weiterer Gegenstand ist ein Bauelement, insbesondere ein mikromechanisches und/oder ein mikrofluidisches und/oder ein mikroelektronisches Bauelement, herstellbar gemäß einem erfindungsgemäßen Verfahren. Besonders bevorzugt ist hierbei, dass als Strukturparameter des strukturierten Materialbereichs insbesondere die Dichte der Mikropartikel des ersten Materials innerhalb der Matrix des zweiten Materials sowie die Größe und/oder die Form der Mikropartikel vorgesehen ist und dass das Bauelement wenigstens einen weiteren strukturierten Materialbereich mit gegenüber dem strukturierten Materialbereich unterschiedlich eingestellten Strukturparametern aufweist. Hierdurch ist es durch mannigfache Variation der Abscheidebedingungen während des ersten erfindungsgemäßen Schrittes des Herstellungsverfahrens möglich, sehr unterschiedliche und insbesondere für unterschiedliche Anwendungen geeignete strukturierte Membtanbereiche zu erzeugen. Ferner ist es erfindungsgemäß auch möglich, während der Erzeugung des strukturierten Materialbereichs die Abscheidebedingungen kontinuierlich und/oder diskontinuierlich und/oder periodisch wechselnd derart zu verändern, dass in unterschiedlichen Abscheidebereichen unterschiedliche Strukturparameter vorliegen.

Besonders bevorzugt ist es, dass der strukturierte Materialbereich und/oder der weitere strukturierte Materialbereich des Bauelements als chemosensorische Membran, insbesondere als NH3-sensierende Membran, und/oder als semipermeable Membran, insbesondere für Dialyseanwendungen, und/oder als Filter, insbesondere zur Filterung von chemisch aggressiven Flüssigkeiten, und/oder als thermisch entkoppelnde Membran, insbesondere für ein Mikrobolometer, vorgesehen ist. Hierdurch ist es vorteilhaft möglich, eine Vielzahl von möglichen Anwendungen für den strukturierten Materialbereich bzw. für den porozifizierten strukturierten Materialbereich zu erschließen. Entsprechend ist ein weiterer Gegenstand der vorliegenden Erfindung die Verwendung eines Bauelements als Chemosensor und/oder als Membran und/oder als Filter und/oder als Sensor, was die Anwendungsmöglichkeiten des Bauelements weiter erhöht.

### Kurze Beschreibung der Zeichnung

Ausführungsbeispiele der Erfindung sind in der Zeichnung dargestellt und in der nachfolgenden Beschreibung näher erläutert.

Es zeigen:
- Figur 1: eine schematische Querschnittsdarstellung eines - Bauelements gemäß einer zweiten Ausführungsform desselben,
- Figur 2: eine schematische Querschnittsdarstellung des Bauelements gemäß einer ersten Ausführungsform desselben,
- Figur 3: eine schematische Querschnittdarstellung einer Detaildarstellung eines strukturierten Materialbereichs des Bauelements,
- Figuren 4 und 5: schematische Darstellungen von Varianten des strukturierten Materialbereichs in einem Bauelement und
- Figur 6: eine schematische Darstellung einer Vorrichtung zur Herstellung bzw. des erfindungsgemäßen Verfahrens zur Herstellung des Bauelements.

### Ausführungsform(en) der Erfindung

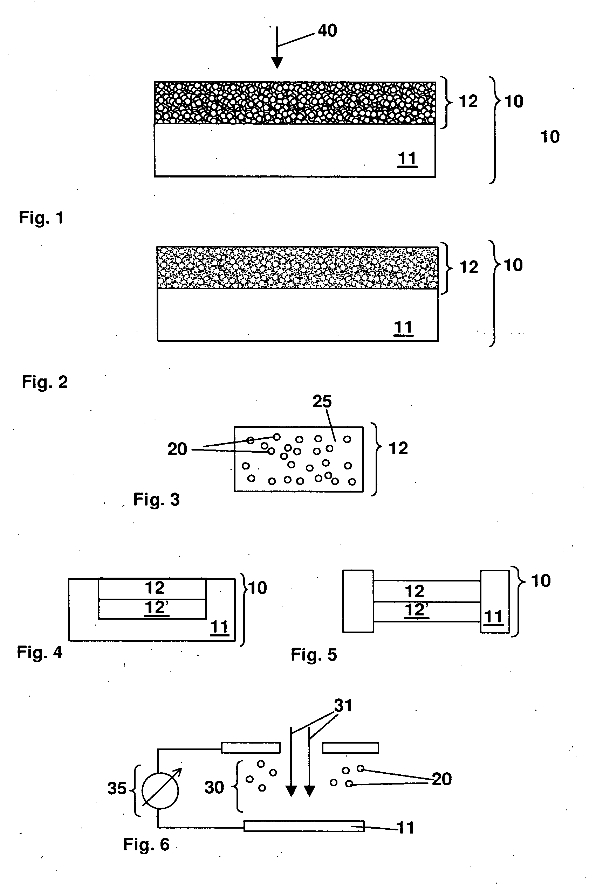

In Figur 1 ist eine schematische Querschnittsdarstellung durch ein - Bauelement 10 gemäß einer zweiten Ausführungsform der Erfindung bzw. in Figur 2 gemäß einer ersten Ausführungsform der Erfindung dargestellt. Bei beiden Ausführungsformen umfasst das Bauelement 10 einen strukturierten Materialbereich 12. Dieser strukturierte Materialbereich 12 ist in Figur 3 in einer Detaildarstellung in schematischen Querschnittsdarstellung abgebildet. Hierbei ist der strukturierte Materialbereich 12 derart vorgesehen, dass Mikropartikel 20 (die im Folgenden auch als Partikel 20 bezeichnet werden) in einer Matrix 25 eingebettet sind. Die Mikropartikel 20 umfassen im wesentlichen ein erstes Material und die Matrix 25 umfasst im wesentlichen ein zweites Material. Weiterhin ist sowohl in Figur 1 als auch in Figur 2 ein Substrat 11 welches das Bauelement 10 beispielhaft aufweist.

Der Unterschied zwischen der ersten Ausführungsform (Figur 2) und der zweiten Ausführungsform (Figur 1) ist der, dass bei der ersten Ausführungsform (Figur 2) eine Ätzung entweder des ersten Materials (also der Mikropartikel 20) relativ zum zweiten Material (also der Matrix 25) oder umgekehrt des zweiten Materials relativ zum ersten Material stattgefunden hat, während bei der zweiten Ausführungsform (Figur 1) keine solche Ätzung durchgeführt wurde. Die durchgeführte Ätzung bei der ersten Ausführungsform des Bauelements 10 ist in der Figur 2 mittels einer gestrichelten bzw. punktierten Darstellung der einzelnen Mikropartikel 20 innerhalb des strukturierten Materialbereichs 12 angedeutet. Hierbei ist es so, dass der strukturierte Materialbereich 12 im Folgenden sowohl mit als auch ohne die durchgeführte Ätzung als strukturierter Materialbereich 12 bezeichnet wird, weil die durch die Einbettung der Partikel 20 in die Matrix 25 im strukturierten Materialbereich 12 erzeugte Struktur sowohl ohne Ätzung vorhanden ist als auch bei einer selektiven Ätzung entweder der Partikel 20 gegenüber der Matrix 25 (bzw. umgekehrt) vorhanden ist.

In den Figuren 4 und 5 sind verschiedene Varianten von Anordnungen des strukturierten Materialbereichs 12 bzw. des Substrats 11 innerhalb des Bauelements 10 dargestellt. Hierbei ist auch die Möglichkeit dargestellt, dass neben dem strukturierten Materialbereich 12 ein weiterer strukturierter Materialbereich 12' vorhanden ist. Hierbei wird im Rahmen der vorliegenden Erfindung unter einem weiteren strukturierten Materialbereich 12' insbesondere ein solcher Materialbereich verstanden, der andere Strukturparameter hinsichtlich seiner Strukturierung (der Partikel 20 innerhalb der Matrix 25) aufweist, also beispielsweise derart, dass die Partikel 20 größer sind, oder eine andere Form aufweisen oder aber dass die Partikel 20 zwar in derselben Größe vorliegen, jedoch mit einer geringeren Dichte (innerhalb der Matrix 25) verteilt vorliegen.

Das erfindungsgemäße Verfahren zur Erzeugung des strukturierten Materialbereichs 12 sowohl gemäß der ersten Ausführungsform als auch gemäß der zweiten Ausführungsform des Bauelements 10 ist in Figur 6 dadurch angedeutet dargestellt, dass schematisch eine Anordnung zur Durchführung des ersten Schrittes gemäß des Herstellungsverfahrens dargestellt ist. Gemäß dem ersten Schritt des erfindungsgemäßen Verfahrens wird der strukturierte Materialbereich 12 dadurch hergestellt, dass Mikropartikel 20 des ersten Materials in der Matrix 25 des zweiten Materials eingebettet werden. Falls nachfolgend eine Porosifizierung des strukturierten Materialbereichs 12 gewünscht wird, kann erfindungsgemäß mittels eines Gasphasenätzverfahrens (bzw. Trockenätzverfahrens) in einem zweiten Verfahrensschritt die gewünschte Ätzung erfolgen, ohne dass die Nachteile eines nasschemischen Ätzverfahrens auftreten. Diese Möglichkeit ist in Figur 1 mit einem Pfeil und dem Bezugszeichen 40 angedeutet, welches der Bezeichnung des Ätzmediums bzw. das Ätzgases 40 dient.

Das erfindungsgemäße Verfahren wird nachfolgend vorrangig am Beispiel der Einbettung von Germanium-Mikropartikeln 20 bzw. von Silizium-Germanium-Mikropartikeln 20 in eine Matrix 25 umfassend vorwiegend Silziumcarbid beispielhaft beschrieben. Jedoch ist es erfindungsgemäß auch möglich, dass andere Materialkombinationen zwischen den Mikropartikeln 20 und der Matrix 25 gewählt werden.

Gemäß dem ersten Schritt des erfindungsgemäßen Verfahrens wird der strukturierte Materialbereich 12 als Einbettung von Germanium-Mikropartikeln bzw. Silizium-Germanium-Mikropartikeln 20 bzw. Mikrokristalliten 20 in einer Matrix 25 aus beispielsweise amorphem Siliziumcarbid erzeugt. (Nach einer Ätzung der Mikropartikel 20 im zweiten Verfahrensschritt ist es möglich, dass mittels eines thermischen Verfahrensschritts (nicht dargestellt) - beispielsweise durch ein sogenanntes Rapid Thermal Processing - eine Umwandlung des porösen amorphen Siliziumcarbids in poröses polykristallines Siliziumcarbid herbeigeführt wird.)

Zur Herstellung des strukturierten Materialbereichs 12 wird erfindungsgemäß beispielsweise einen PECVD-Prozess (plasma enhanced chemical vapor deposition) eingesetzt. In diesem Prozess werden die im Laufe des Abscheidungs- bzw. Beschichtungsverfahrens schichtbildenden Stoffe (die im folgenden auch als Vorläuferedukte 31 oder auch als Precursors 31 bezeichnet werden) vorzugsweise in gasförmiger Form zugeführt. Dies ist in Figur 6 mittels zweier Pfeile an den Vorläuferedukten 31 angedeutet. Als schichtbildende Vorläuferedukte 31 können beispielsweise für Germanium-Mikropartikel bzw. Silizium-Germanium-Mikropartikel 20 German (GeH4) bzw. German (GeH4) und Silan (SiH4) vorgesehen sein, während für die Siliziumcarbid umfassende Matrix 25 als Vorläuferedukte 31 Silan (SiH4) und Methan (CH4) vorgesehen sein können. Diese Vorläuferedukte 31 werden erfindungsgemäß beispielsweise gleichzeitig einer Plasmaentladung zugeführt, wobei der Bereich eines Plasmas in Figur 6 mit dem Bezugszeichen 30 angedeutet ist. Als weitere Beispiele von Vorläuferedukten 31 zur Bildung von Siliziumcarbid kommen alle Silizium-Kohlenwasserstoffe (SikCmHn) und deren Gemische bzw. Isomere erfindungsgemäß in Betracht.

Ferner ist in Figur 6 dargestellt, dass bei der Erzeugung des strukturierten Materialbereichs 12 beispielhaft an das Substrat 11 sowie an Elektroden (in Figur 6 nicht mittels Bezugszeichen bezeichnet) eine Spannung zur Erzeugung des Plasmas 30 angelegt werden kann. Hierbei können übliche Plasmabeschichtungsanlagen, etwa ein kapazitiver Parallelplattenreaktor (parallel plate reactor) oder aber eine induktiv gekoppelte Quelle (ICP, inductively coupled plasma)-[richtig?] - beispielsweise mit dargestellter Substratelektrode - Verwendung finden. Erfindungsgemäß wird die große Differenz in den Kristall-Bindungsenergien zwischen verschiedenen Materialien zur Ausbildung des strukturierten Materialbereichs 12 ausgenutzt. Beispielsweise betragen die Kristall-Bindungsenergien für Siliziumcarbid etwa 5 eV und für Germanium bzw. Silizium-Germanium ca. 2 eV, was dazu führt, dass bei typischen Prozesstemperaturen von beispielsweise etwa 300 °C Siliziumcarbid in amorpher Phase aufwächst, während die Temperatur des Substrats und die Energie aus dem Plasma bereits ausreichend sind, dass sich Germanium-Mikrokristallite bzw. Silizium-Germanium-Mikrokristallite (zunächst im Plasma) ausbilden, die anschließend in die Matrix aus amorphem Siliziumcarbid eingebettet werden. Erfindungsgemäß ist es überraschend möglich, sogenannte staubige Plasmen (dusty plasma) - welche bisher eher als Nachteil bei der Abscheidung von Materialschichten angesehen wurden - vorteilhaft zur Erzeugung des strukturierten Materialbereichs 12 auszunutzen. Hierbei werden Kristallite 20 bzw. Mikrokristallite 20 des ersten Materials, die im Bereich eines solchen Plasmas 30 entstehen, zusammen mit dem zweiten Material abgeschieden, wodurch die Strukturierung des strukturierten Materialbereichs 12 erzielt wird. Es ist nämlich so, dass beispielsweise Silanhaltige bzw. Germanhaltige Niederdruck-Plasmen zur Bildung von Partikeln im Plasma neigen (dusty plasma). Diese Partikel sind im Bereich von einigen Nanometern bis zu einem oder mehreren Mikrometern große Kristallite, die sich im Volumen der Entladung bilden, da sie sich durch die freien Elektronen der Gasentladung (bzw. des Plasmas 30) elektrisch negativ aufladen und vermöge dieser elektrischen Ladung in der elektrischen Schicht (Raumladungszone) zwischen dem Plasma 30 und dem Substrat 11 bzw. der Substratelektrode 11 quasi schwebend gehalten werden.

Dort wachsen sie (bei eingeschaltetem Plasma 30) so lange bis sie so schwer sind, dass sie (schwerkraftbedingt) auf das Substrat 11 fallen. Dieser Dusty-Plasma-Effekt wird erfindungsgemäß zum Vorteil ausgenutzt, um die Mikropartikel 20 in die Matrix 25 einzubetten. Hierzu kann erfindungsgemäß entweder das Plasma 30 dauerhaft eingeschaltet bleiben (und der schwerkraftbedingte Beschichtungsprozess bzw. Einbettungsprozess der Partikel 20 ausgenutzt werden) oder aber es kann das Plasma 30 gepulst werden, d.h. periodisch ein- und ausgeschaltet werden, so dass über die Einschaltzeit die Bildung der Partikel 20 und deren Größe einstellbar ist und über die Ausschaltzeit die Einbettung der Partikel 20 in die Matrix 25 erfolgen kann. Hierzu ist in Figur 6 eine Plasmasteuerung 35 - insbesondere als Leistungs-Spannungssteuerung der Entladungsspannungangedeutet dargestellt.

Durch die erfindungsgemäße Zugabe von Wasserstoff (in Figur 6 nicht dargestellt) in die Entladung bzw. in das Plasma 30 lässt sich die Kristallisation von Germanium bzw. von Silizium-Germanium beschleunigen. Über den Wasserstoffgehalt und die eingeprägte Leistung des Plasmas 30 ist es erfindungsgemäß daher möglich, die Größenverteilung der Germanium-Mikrokristallite bzw. der Silizium-Germanium-Mikrokristallite 20 gezielt zu steuern. Hierdurch lässt sich durch die Beschichtungsbedingungen des Plasmas 30 während des ersten Schrittes des erfindungsgemäßen Verfahrens insbesondere die Größe der Mikrokristallite 20 bzw. der Partikel 20 als ein wesentlicher Strukturparameter des strukturierten Materialbereichs 12 einstellen bzw. in einfacher Weise steuern. Als zusätzliches Trägergas für die Plasmaentladung kommt erfindungsgemäß beispielsweise Argon aber auch alle anderen inerten Gase, wie zum Beispiel Helium, Neon oder Stickstoff in Betracht.

Je nach der Art bzw. der Anordnung der Zuführung der Vorläuferedukte 31 ist es erfindungsgemäß auch möglich, dass weitere Strukturparameter der Partikel 20 und damit des strukturierten Materialbereichs 12 beeinflusst werden. Beispielsweise kann hierdurch die Form der Partikel 20 und/oder die Dichte der Partikel 20 (als Anzahl der Partikel pro Substratfläche) variiert werden. Ferner ist es erfindungsgemäß möglich, dass eine laterale Änderung der Plasmabedingungen zu einer lateralen Änderung der Strukturparameter des strukturierten Materialbereichs 12 führt.

Eine vertikale Differenzierung zwischen unterschiedlichen Bereichen des strukturierten Materialbereichs 12 bzw. zwischen verschiedenen, aneinander angrenzenden Materialbereichen 12, 12' kann erfindungsgemäß über ein sogenanntes Parameterramping (d.h. eine zeitliche Veränderung der Plasmabedingungen derart, dass mit zunehmender Beschichtungszeit und damit auch mit zunehmender Schichtdicke des strukturierten Materialbereichs 12) unterschiedliche Beschichtungsbedingungen im Plasma vorliegen und damit auch unterschiedliche Strukturparameter in unterschiedlichen Bereichen des strukturierten Materialbereichs 12 hergestellt werden. Ein solches Parameterramping kann beispielsweise in den Gaszuflüssen bzw. Gasflüssen der Vorläuferedukte 31 und/oder in den elektrischen Parametern der Entladung und/oder im Entladungsdruck erfolgen. Es kann somit beispielsweise eine über die Schichtdicke des strukturierten Materialbereichs 12 variable Partikel-Größenverteilung eingestellt werden, wodurch sich während des Ätzvorgangs im zweiten Verfahrensschritt auch unterschiedliche Porengrößen ergeben.

Alternativ zu der Erzeugung von Germanium-Krstalliten 20 bzw. von Silizium-Germanium-Kristalliten 20 in einer Matrix 25 aus vorwiegend Siliziumcarbid ist es erfindungsgemäß auch möglich, dass als Matrix 25 amorphesporöses Silizium verwendet wird. Hierbei können ebenfalls Germanium-Kristallite 20 bzw. Silizium-Germanium-Kristallite 20 in diese Matrix 25 eingebettet werden. Auch hierbei ist es möglich, eine Porosifizierung des strukturierten Materialbereichs 12 durch Ätzung mittels eines Trockenätzverfahrens und damit (amorphes) poröses Silizium zu erhalten, was insbesondere durch die hohe Ätzselektivität (von etwa 1 zu 4000 (beispielsweise bei einer Ätzung mit ClF3)) zwischen Silizium einerseits sowie Germanium bzw. Silizium-Germanium andererseits möglich ist.

## Patentansprüche

1. Verfahren zur Herstellung eines Bauelements (10), insbesondere ein mikromechanisches und/oder mikrofluidisches und/oder rnikroelektronisches Bauelement (10), mit wenigstens einem strukturierten Materialbereich (12), **dadurch gekennzeichnet, dass** in einem ersten Schritt der strukturierte Materialbereich (12) dadurch hergestellt wird, dass Mikropartikel (20) eines ersten Materials in einer Matrix (25) eines zweiten Materials eingebettet werden und dass in einem zweiten Schritt der strukturierte Materialbereich (12) mittels eines Trockenätzverfahrens oder eines Gasphasenätzverfahrens porös geätzt wird, wobei der strukturierte Materialbereich (12) im zweiten Schritt dadurch porös geätzt wird, dass das erste Material selektiv gegenüber dem zweiten Material geätzt wird oder dass das zweite Material selektiv gegenüber dem ersten Material geätzt wird, wobei zur Herstellung des strukturierten Materialbereichs (12) im ersten Schritt ein Abscheidungsverfahren verwendet wird, bei dem die Mikropartikel (20) innerhalb eines Plasmas (30) aus Vorläuferedukten (31) entstehen.

2. Verfahren nach Anspruch 1, **dadurch gekennzeichnet, dass** die Vorläuferedukte (31) insbesondere gasförmig sind.

3. Verfahren nach einem der vorhergehenden Ansprüche, **dadurch gekennzeichnet, dass** die Mikropartikel (12) des ersten Materials Germanium oder Siliziumgermanium umfassende Mikrokristallite sind und/oder dass die Matrix des zweiten Materials Siliziumcarbid oder Silizium umfasst.

4. Verfahren nach einem der vorhergehenden Ansprüche, **dadurch gekennzeichnet, dass** bei dem im ersten Schritt zur Herstellung des strukturierten Mäterialbereichs (12) verwendeten Abscheidungsverfahrens eine Plasmasteuerung (35) zur periodischen Erzeugung und Abscheidung von Mikropartikel (20) verwendet wird, wobei insbesondere die Größe und/oder die Form der Mikropartikel (20) durch eine Variation der Plasmasteuerung (35) verändert wird und wobei insbesondere eine Spannungssteuerung als Plasmasteuerung (35) verwendet wird.

## Claims

1. Method for producing a component (10), in particular a micromechanical and/or microfluidic and/or microelectronic component (10), having at least one patterned material region (12), **characterized in that**, in a first step, the patterned material region (12) is produced by virtue of the fact that microparticles (20) of a first material are embedded in a matrix (25) of a second material, and **in that**, in a second step, the patterned material region (12) is rendered porous by etching by means of a dry etching method or a gas phase etching method, wherein the patterned material region (12) is rendered porous by etching in the second step by virtue of the fact that the first material is selectively etched with respect to the second material or that the second material is selectively etched with respect to the first material, wherein the patterned material region (12) is produced in the first step by using a deposition method, in which the microparticles (20) develop from precursor reagents (31) within a plasma (30).

2. Method according to Claim 1, **characterized in that** the precursor reagents (31) are in particular gaseous.

3. Method according to either of the preceding claims, **characterized in that** the microparticles (12) of the first material are microcrystallites comprising germanium or silicon germanium and/or **in that** the matrix of the second material comprises silicon carbide or silicon.

4. Method according to one of the preceding claims, **characterized in that** a plasma control (35) for periodically producing and depositing microparticles (20) is used in the deposition method used in the first step for producing the patterned material region (12), wherein in particular the size and/or the form of the microparticles (20) is modified by varying the plasma control (35) and wherein in particular a voltage control is used as the plasma control (35).

## Revendications

1. Procédé de fabrication d'un composant (10), en particulier d'un composant (10) micromécanique et/ou microfluidique et/ou microélectronique, comprenant au moins une région de matériau structurée (12), **caractérisé en ce que** dans une première étape, la région de matériau structurée (12) est fabriquée en noyant des microparticules (20) d'un premier matériau dans une matrice (25) d'un deuxième matériau et **en ce que** dans une deuxième étape, la région de matériau structurée (12) est gravée de manière à être rendue poreuse au moyen d'un procédé de gravure à sec ou d'un procédé de gravure en phase gazeuse, la région de matériau structurée (12), dans la deuxième étape, étant gravée de manière à être rendue poreuse en gravant le premier matériau de manière sélective par rapport au deuxième matériau, ou en gravant le deuxième matériau de manière sélective par rapport au premier matériau, et pour la fabrication de la région de matériau structurée (12), dans la première étape, un procédé de déposition étant utilisé, dans lequel les microparticules (20) se forment à l'intérieur d'un plasma (30) à partir d'éduits précurseurs (31).

2. Procédé selon la revendication 1, **caractérisé en ce que** les éduits précurseurs (31) sont notamment gazeux.

3. Procédé selon l'une quelconque des revendications précédentes, **caractérisé en ce que** les microparticules (12) du premier matériau sont des microcristallites comprenant du germanium ou du silicium-germanium et/ou **en ce que** la matrice du deuxième matériau comprend du carbure de silicium ou du silicium.

4. Procédé selon l'une quelconque des revendications précédentes, **caractérisé en ce que** dans le procédé de déposition utilisé dans la première étape pour fabriquer la région de matériau structurée (12), on utilise une commande à plasma (35) pour produire et déposer de manière périodique des microparticules (20), la taille et/ou la forme des microparticules (20) étant notamment modifiées par une variation de la commande à plasma (35) et notamment une commande de tension étant utilisée en tant que commande à plasma (35).
